# EUROPEAN PATENT APPLICATION

(11) **EP 4 701 223 A1**
(43) Date of publication of application: **25.02.2026**
(21) Application number: 23962953.8
(22) Date of filing: 29.12.2023
(51) Int. Cl.: H04R 1/10

(54) **SUPRA-AURAL EARPHONE**

(71) Applicant: Shenzhen Shokz Co., Ltd., Shenzhen, Guangdong 518108 (CN)
(72) Inventor: YUE, Gong, Shenzhen, Guangdong 518108 (CN); KE, Hao, Shenzhen, Guangdong 518108 (CN)
(74) Representative: Santarelli
(86) International application number: PCT/CN2023/143668
(87) International publication number: WO 2025/138279

(57) **Abstract**

This specification provides a headphone, the headphone is provided with a dual-layer circuit board structure within the circuit board compartment, so that the vertical space of the circuit board compartment perpendicular to the first circuit board surface is fully utilized, thereby meeting more circuit expansion requirements without expanding the circuit board compartment, such as requirements for storage and playback of audio data. Furthermore, the headphone provided by this specification can use other models of headphone housing, without the need to redesign and re-mold, thereby reducing development and production costs.

## Description

### Technical Field

This specification relates to the field of acoustic equipment, and particularly relates to an ear hook headphone.

### Background of the Invention

With the improvement of people's comfort requirements for wearable devices, wearable devices are increasingly developing toward miniaturization and lightweight design. At the same time, people's functional demands for electronic devices are also continuously increasing, which inevitably requires expanding functions through hardware circuits, which also means an increase in circuit area.

As a type of wearable electronic device, ear hook headphone also faces the contradiction of how to control the volume and weight of the device body while achieving circuit expansion.

Therefore, there is a need to provide a headphone that can integrate more circuits within limited device space.

The content of the background technology section is only information known to the applicant personally, and does not represent that the above information has entered the public domain before the filing date of this disclosure, nor does it represent that it can become prior art of this disclosure.

### Summary of the Invention

This specification provides an ear hook headphone that can achieve circuit area expansion within a limited circuit board compartment.

This specification provides an ear hook headphone, including: a speaker unit, configured to convert an input into a sound; a circuit board compartment, including an accommodation space; and a first circuit board, a second circuit board, and a connector, where the first circuit board and the second circuit board are connected within the accommodation space via the connector, forming a dual-layer circuit board structure to utilize a vertical space of the circuit board compartment perpendicular to a surface of the first circuit board.

In some embodiments, the connector is a board-to-board connector, the first circuit board and the second circuit board are arranged in parallel on two sides relative to the board-to-board connector, forming the dual-layer circuit board structure; or the connector includes a flexible circuit board, the first circuit board and the second circuit board are foldably connected via the flexible circuit board and arranged in parallel, forming the dual-layer circuit board structure.

In some embodiments, in a board surface direction of the first circuit board, a ratio of an overlapping area of the first circuit board and the second circuit board to a union area of the first circuit board and the second circuit board is greater than or equal to 0.2.

In some embodiments, a ratio of a maximum cross-sectional area of the accommodation space to the union area of the first circuit board and the second circuit board in the board surface direction of the first circuit board is less than or equal to 1.5.

In some embodiments, a ratio of a thickness of the circuit board compartment to a thickness of the dual-layer circuit board structure is less than or equal to 1.5, where the thickness of the dual-layer circuit board structure is a maximum distance between the first circuit board and components on the first circuit board and the second circuit board and components on the second circuit board in a direction perpendicular to the board surface direction of the first circuit board.

In some embodiments, the thickness of the circuit board compartment is in a range of 0.6 centimeters to 1 centimeter.

In some embodiments, a length of the circuit board compartment is in a range of 3 centimeters to 4 centimeters.

In some embodiments, the second circuit board includes a data unit; the data unit and the first circuit board perform mutual signal transmission through the connector during operation, where the first circuit board and the second circuit board are arranged in dual layers.

In some embodiments, the data unit includes: a data input and output circuit, disposed on a side of the second circuit board facing the first circuit board; and a memory, storing audio data, electrically connected to the data input and output circuit, the memory being disposed on a side of the second circuit board away from the first circuit board.

In some embodiments, the headphone further includes an MP3 module, where the MP3 module includes at least a portion of the second circuit board.

In some embodiments, the headphone further includes: a signal shielding component, at least partially covering the data input and output circuit to at least partially block electromagnetic radiation generated during audio data transmission.

In some embodiments, the headphone further includes a conductive buffer pad, located between the first circuit board and the signal shielding component and abutting against the first circuit board and the signal shielding component, to enhance an electrical connection of ground lines of the first circuit board and the second circuit board, thereby reducing a signal loop area between the first circuit board and the second circuit board.

In some embodiments, a housing of the circuit board compartment includes at least one positioning post; and the first circuit board and the second circuit board each include at least one positioning hole and/or at least one positioning notch, where the at least one positioning post is inserted through the at least one positioning hole or the at least one positioning notch to fix the first circuit board and the second circuit board in respective board surface directions thereof.

In some embodiments, the at least one positioning post includes at least one target positioning post, and the at least one target positioning post includes a post body and an enlarged post head; the post body is fixedly connected to the housing and passes through the first circuit board and the second circuit board; the post head abuts against a side of the first circuit board or the second circuit board that is far away from the housing, so as to fix the first circuit board and the second circuit board along an axial direction of the post body.

In some embodiments, at least one accommodation cavity is disposed inside the housing of the circuit board compartment to accommodate at least one target component and to restrict movement of the at least one target component along a board surface direction of a circuit board; the target component is a component with a greatest height in a direction perpendicular to the board surface direction of the circuit board; and a depth of the accommodation cavity is less than or equal to a height of the target component relative to a board surface of the circuit board.

In some embodiments, the target component is a memory, and the memory is disposed on the side of the second circuit board away from the first circuit board.

In some embodiments, the headphone further includes a buffer member, where the buffer member is disposed between the first circuit board and the housing of the circuit board compartment, and is in contact with both the first circuit board and the housing.

In some embodiments, the headphone further includes at least one button, where the at least one button is at least partially disposed between the first circuit board and the second circuit board, and is electrically connected to the first circuit board or the second circuit board, where the housing further includes at least one button hole, and the at least one button is inserted through the at least one button hole.

In some embodiments, a thickness of the button is less than or equal to a distance between the first circuit board and the second circuit board.

In some embodiments, the headphone is a first model headphone, and the circuit board compartment has same shape and size as a circuit board compartment of a second model headphone, and the circuit board compartment of the second model headphone does not include a second circuit board.

From the above technical solutions, it can be seen that the headphone provided in this specification sets up a dual-layer circuit board structure within the circuit board compartment, so that the vertical space perpendicular to the first circuit board surface in the circuit board compartment is fully utilized, thereby meeting more circuit expansion needs without enlarging the circuit board compartment, such as needs for audio data storage and playback. Furthermore, the headphone provided in this specification can use housings of other headphone models without the need to redesign and create new molds, thereby reducing development and production costs.

Other functions of the headphone provided in this specification will be partially listed in the following description. Based on the description, the content introduced by the following numbers and examples will be obvious to a person of ordinary skill in the art. The creative aspects of the headphone provided in this specification can be fully explained through practice or use of the methods, devices and combinations provided in the detailed examples below.

### Brief Description of the Drawings

In order to more clearly illustrate the technical solutions in the embodiments of this specification, the drawings needed for the description of the embodiments will be briefly introduced below. Obviously, the drawings in the following description are only some embodiments of this specification. For a person of ordinary skill in the art, other drawings can also be obtained based on these drawings without creative effort.
FIG. 1 shows a structural schematic diagram of a headphone provided according to some embodiments of this specification;
FIG. 2 shows a partial exploded view of a circuit board compartment provided according to some embodiments of this specification;
FIG. 3 shows a schematic diagram of a dual-layer circuit board structure provided according to some embodiments of this specification;
FIG. 4 shows a schematic diagram of the internal structure of a circuit board compartment provided according to some embodiments of this specification; and
FIG. 5 shows a schematic diagram of a dual-layer circuit board structure provided according to some embodiments of this specification.

### Detailed Description of Embodiments

The following description provides specific application scenarios and requirements of this specification, with the purpose of enabling a person skilled in the art to manufacture and use the content in this specification. For a person skilled in the art, various partial modifications to the disclosed embodiments are obvious, and the general principles defined herein can be applied to other embodiments and applications without departing from the spirit and scope of this specification. Therefore, this specification is not limited to the shown embodiments, but is accorded the widest scope consistent with the claims.

The terminology used herein is for the purpose of describing particular exemplary embodiments only and is not limiting. For example, unless the context clearly indicates otherwise, as used herein, the singular forms "a," "an," and "the" may also include the plural forms. When used in this specification, the terms "include," "comprise," and/or "contain" mean that the associated integers, steps, operations, elements and/or components are present, but do not exclude the presence of one or more other features, integers, steps, operations, elements, components and/or groups, or that other features, integers, steps, operations, elements, components and/or groups may be added to the system/method.

Considering the following description, these and other features of this specification, as well as the operation and function of related elements of the structure, and the combination of components and economy of manufacture can be significantly improved. With reference to the accompanying drawings, all of which form part of this specification. However, it should be clearly understood that the drawings are for illustration and description purposes only and are not intended to limit the scope of this specification. It should also be understood that the drawings are not drawn to scale.

The flowcharts used in this specification illustrate operations implemented by systems according to some embodiments in this specification. It should be clearly understood that the operations of the flowcharts may not be implemented in order. Conversely, the operations may be implemented in reverse order or simultaneously. In addition, one or more other operations may be added to the flowcharts. One or more operations may be removed from the flowcharts.

In this specification, "X includes at least one of A, B, or C" means that X includes at least A, or X includes at least B, or X includes at least C. That is to say, X may include only any one of A, B, or C, or simultaneously include any combination of A, B, or C as well as other possible content/elements. Any combination of A, B, or C may be A, B, C, AB, AC, BC, or ABC.

In this specification, unless explicitly stated, the associative relationships formed between structures can be direct associative relationships or indirect associative relationships. For example, when describing "A is connected to B," unless it is explicitly stated that A is directly connected to B, it should be understood that A can be directly connected to B or indirectly connected to B; for another example, when describing "A is above B," unless it is explicitly stated that A is directly above B (A and B are adjacent and A is above B), it should be understood that A can be directly above B, or A can also be indirectly above B (other elements are between A and B, and A is above B), and so on.

This specification provides an ear hook headphone. This specification does not limit the type of headphone. For example, the headphone can be a bone conduction headphone, or it can be an air conduction headphone, or it can also be a combination of air conduction headphone and bone conduction headphone. In another example, the headphone can be a wired headphone or it can be a wireless headphone.

In some usage scenarios, in order to meet users' functional requirements for headphones, it is sometimes necessary to expand new circuit modules. For example, if users have a need for local music playback, an MP3 module can be designed in the circuit. Or, if users have a need to listen to radio or intercom, a radio module or intercom module can be designed in the circuit. However, the wearing comfort and stability of the headphones cannot be reduced due to expanding circuit functions, that is, the volume of the circuit board compartment cannot be increased to expand the circuit area, which would increase the weight of the circuit board compartment. Therefore, this specification provides a headphone that can set up larger area circuits within limited circuit board compartment space.

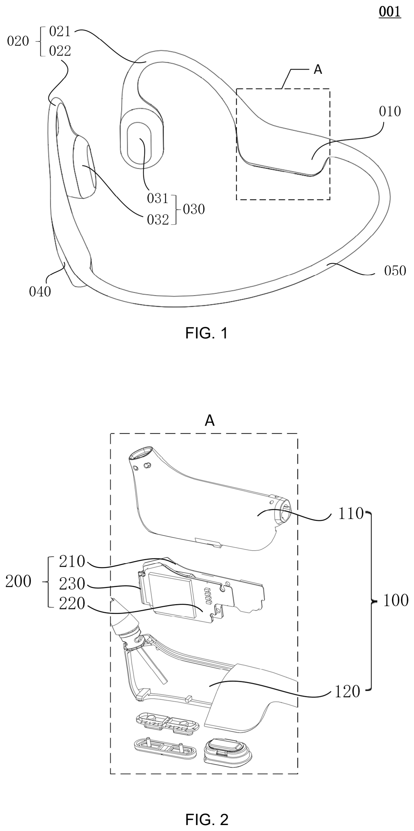

FIG. 1 shows a structural schematic diagram of a headphone 001 provided according to some embodiments of this specification. The headphone 001 provided by this specification may include a speaker unit 030 and a circuit board compartment 010. In some embodiments, the headphone 001 may also include a power compartment 040. The power compartment 040 may include a battery, and the battery is used to supply power to active devices in the headphone.

The speaker unit 030 can convert received audio electrical signals into sound waves. The number of speaker units 030 can be one or two. In some embodiments, for usage scenarios with low stereo requirements, such as hearing assistance for hearing patients and teleprompter for hosts, the number of speaker units 030 can be one. During use, users can wear the headphone on the left ear or right ear. In some embodiments, as shown in FIG. 1, the number of speaker units 030 can be two. Headphones with dual speaker units can be applied to usage scenarios requiring stereo effects, enhancing the listening experience. This specification will use headphones containing two speaker units as an example for introduction.

In some embodiments, the speaker unit 030 can be directly or indirectly connected to the circuit board compartment 010. **In** the headphone shown in FIG. 1, one speaker unit 031 is directly connected to the circuit board compartment 010 through one side ear hook part 021, and another speaker unit 032 is connected to the power compartment 040 through the other side ear hook part 022, then connected to the rear hook part 050 through an adapter inside the power compartment 040, and further indirectly connected to the circuit board compartment 010 through the rear hook part 050.

FIG. 2 shows a partial exploded view provided according to some embodiments of this specification. As shown in the exploded view of area A in FIG. 2, the circuit board compartment 010 can include a housing 100 and an accommodation space formed by the housing 100 surrounding it. The accommodation space can be used to house the circuit board of the headphone 001. The housing 100 can include a first housing 110 and a second housing 120, with the first housing 110 and the second housing 120 together forming the accommodation space.

To meet the wearing comfort requirements of the headphone 001, the shape of the circuit board compartment 010 can be a flat elongated strip. When worn, the side of the circuit board compartment 010 close to the user's skin and the sides of the ear hook part 020 and rear hook part 050 close to the user's skin are roughly on a smooth curved surface, making the headphone 001 conform to ergonomic design, thereby avoiding or reducing the sense of oppression caused by the protrusion of the side of the circuit board compartment 010 close to the user's skin or avoiding the uneven feeling during wearing. To meet the wearing stability requirements of the headphone 001, the volume or mass of the circuit board compartment 010 and power compartment 040 should be as close as possible, thereby avoiding the headphone 001 tilting to one side during wearing. To meet the aesthetic requirements of the headphone 001, the appearance of the headphone 001 can adopt a roughly symmetrical design, that is, the shapes of the circuit board compartment 010 and power compartment 040 can be roughly the same. Under the premise that the headphone 001 design requires miniaturization and weight reduction, the shape and size of the circuit board compartment 010 and power compartment 040 should be controlled as much as possible. Therefore, there is a need to provide a headphone 001 that can expand the circuit board area within the space of the circuit board compartment 010 where shape and volume are limited.

In some embodiments, the thickness of the circuit board compartment 010 is within the range of 0.4 centimeters to 1.6 centimeters. Furthermore, to provide a better wearing experience and reduce or avoid the sense of oppression of the circuit board compartment 010 on the user's skin, in some embodiments, the thickness of the circuit board compartment 010 is within the range of 0.5 centimeters to 1.3 centimeters. In some embodiments, the thickness of the circuit board compartment 010 is within the range of 0.6 centimeters to 1 centimeter. In some embodiments, the length of the circuit board compartment 010 is within the range of 2 centimeters to 5 centimeters. Furthermore, to enhance the wearing stability of the headphone 001 and prevent the overall center of gravity of the headphone 001 from shifting backward due to the circuit board compartment 010 being too long, in some embodiments, the length of the circuit board compartment 010 is within the range of 2.5 centimeters to 4.5 centimeters. **In** some embodiments, the length of the circuit board compartment 010 is within the range of 3 centimeters to 4 centimeters. The maximum distance between the side of the circuit board compartment 010 away from the user's skin and the side close to the user's skin is the thickness of the circuit board compartment 010, and the distance between the connection part of the circuit board compartment 010 and ear hook part 020 and its connection part with the rear hook part 050 is the length of the circuit board compartment 010.

The headphone 001 provided in this specification designs the circuit on the first circuit board 210 and the second circuit board 220 to expand the area of the circuit board, and makes full use of the accommodation space of the circuit board compartment 010 by arranging the two circuit boards in a dual-layer configuration.

Limited by the space of the circuit board compartment 010, it is necessary to consider improving the utilization rate of the accommodation space in the direction perpendicular to the board surface of the first circuit board 210. The thickness of the dual-layer circuit board structure 200 is its actual required vertical space. Since there are components of varying heights on the circuit board, the thickness is the maximum distance between the first circuit board 210 and its components and the second circuit board 220 and its components in the direction perpendicular to the board surface of the first circuit board 210. As mentioned earlier, the thickness of the circuit board compartment 010 is the maximum distance between the side of the circuit board compartment 010 away from the user's skin and the side close to the user's skin. The ratio of the thickness of the circuit board compartment 010 to the thickness of the dual-layer circuit board structure 200 is greater than 1.0. The closer this ratio is to 1.0, the higher the utilization rate of the dual-layer circuit board structure 200 for the accommodation space in the direction perpendicular to the board surface of the first circuit board 210. **In** some embodiments, the ratio of the thickness of the circuit board compartment 010 to the thickness of the dual-layer circuit board structure 200 is less than or equal to 1.5.

Furthermore, it is also necessary to consider improving the utilization rate of the accommodation space in the direction parallel to the board surface of the first circuit board 210. The union area of the first circuit board 210 and the second circuit board 220 in the direction along the board surface of the first circuit board 210 is the area that the dual-layer circuit board structure 200 actually requires at minimum. The union area should be smaller than the cross-sectional area of the accommodation space in that direction, that is, the ratio of the maximum cross-sectional area of the accommodation space to the union area of the first circuit board 210 and the second circuit board 220 in the direction along the board surface of the first circuit board 210 is greater than 1.0. The closer this ratio is to 1.0, the higher the utilization rate of the dual-layer circuit board structure 200 for the accommodation space in the direction along the board surface of the first circuit board 210. In some embodiments, the ratio of the maximum cross-sectional area of the accommodation space to the union area of the first circuit board 210 and the second circuit board 220 in the direction along the board surface of the first circuit board 210 is less than or equal to 1.5.

In addition to considering the overall spatial utilization rate of the dual-layer circuit board structure 200 in the board surface direction, the relative position between the two circuit boards inside the dual-layer circuit board structure 200 should also be considered. The first circuit board 210 and the second circuit board 220 are arranged in a dual-layer configuration, and their overlapping area in the direction along the board surface of the first circuit board 210 is greater than 0. In some technical fields, IoU (intersection over union) is used to measure the degree of similarity between two indicators to be compared. For the dual-layer circuit board structure 200 of the headphone 001 provided in this specification, IoU can be used to measure the degree of overlap between the two circuit boards. In the board surface direction of the first circuit board 210, the ratio of the overlapping area of the first circuit board 210 and the second circuit board 220 to their union area, which is the loU, is less than or equal to 1.0. Only when the first circuit board 210 and the second circuit board 220 have the same area and completely overlap, can the loU reach 1.0. The closer the loU is to 1.0, the greater the degree of overlap between the two circuit boards of the dual-layer circuit board structure 200. In some embodiments, in the board surface direction of the first circuit board 210, the ratio of the overlapping area of the first circuit board 210 and the second circuit board 220 to their union area is greater than or equal to 0.2.

In summary, the headphone 001 provided in this specification forms a dual-layer circuit board structure 200 by combining the first circuit board 210 and the second circuit board 220 to utilize the vertical space perpendicular to the board surface of the first circuit board 210 in the circuit board compartment 010. Furthermore, through the overlapping arrangement of the dual-layer circuit board structure 200, the lateral space parallel to the board surface of the first circuit board 210 in the circuit board compartment 010 can be utilized.

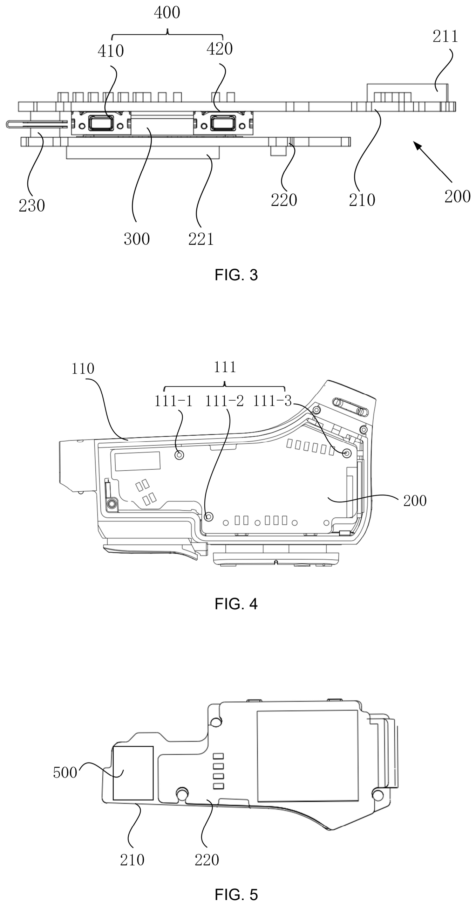

FIG. 3 shows a schematic diagram of a dual-layer circuit board structure 200 provided according to some embodiments of this specification. The dual-layer circuit board structure 200 can include a first circuit board 210, a second circuit board 220, and a connector 230. The connector 230 can be used to connect the first circuit board 210 and the second circuit board 220, making the first circuit board 210 and the second circuit board 220 electrically conductive. For example, the connector 230 can be a board-to-board connector as shown in FIG. 3, with the first circuit board 210 and the second circuit board 220 arranged parallel on both sides of the board-to-board connector, forming the dual-layer circuit board structure 200. For example, the connector 230 can include a flexible circuit board, with the first circuit board 210 and the second circuit board 220 foldably connected through the flexible circuit board and arranged in parallel, forming the dual-layer circuit board structure 200. **In** some embodiments, the connector 230 further includes terminal connectors used in conjunction with the flexible circuit board. For another example, the connector 230 can also be wires, with the first circuit board 210 and the second circuit board 220 foldably connected through wires and arranged in parallel, forming the dual-layer circuit board structure 200.

In some embodiments, the first circuit board 210 can include a control element, and the control element can be an MCU (Microcontroller Unit). The control element can send control signals or instructions to connected components, or perform unidirectional or bidirectional transmission of data signals with them. In some embodiments, the control element can be connected to radio frequency devices for receiving and transmitting wireless signals, for example, it can communicate with external media players or host devices through at least one of Bluetooth, NFC, or WiFi. In some embodiments, the control element can achieve wired communication with host devices through wired transmission interfaces. **In** some embodiments, the control element can perform audio data decoding or digital-to-analog conversion, converting digital signals to analog signals and then transmitting them to the speaker unit.

In some embodiments, the first circuit board 210 can include a power amplifier element. The power amplifier element is used to amplify the power of received analog signals and then transmit them to the speaker so that the sound can be heard by people. The control element and the power amplifier element are electrically connected to receive control signals or sound electrical signals sent by the control element.

In some embodiments, the first circuit board 210 can also include a Bluetooth antenna 211, and the control element can establish connections with external devices through the Bluetooth antenna 211, receive and play audio data sent by external media players, that is, perform music playback through Bluetooth connection.

The headphone 001 provided in this specification can perform local audio playback. In some embodiments, the local audio playback function can be implemented through an MP3 module. The functions of the MP3 module can include at least one of importing and storing audio files, decoding and playing audio files, volume adjustment, or song switching. The MP3 module can include at least part of the components and corresponding circuits on the second circuit board 220. Specifically, the MP3 module can be completely disposed on the second circuit board 220, or the MP3 module can be partially disposed on the second circuit board 220 and partially disposed on the first circuit board 210. For example, the audio storage unit can be disposed on the second circuit board 220, and the volume buttons can be disposed on the first circuit board 210.

The MP3 module can include a data unit. The data unit can import audio data from external devices and store it. The data unit can read the stored audio data during audio playback and play it through the speaker. In some embodiments, the second circuit board 220 can include a data unit, and the data unit and the first circuit board 210 perform signal transmission between each other through the connector 230 during operation. During data import, the control unit on the first circuit board 210 can synchronize clock signals with the data unit, and the connector 230 can connect the clock signals. During data reading, the control unit on the first circuit board 210 can receive audio data from the data unit. In some embodiments, the data unit can include a data input/output circuit and a memory 221. The memory 221 is used to store audio data, and the memory is electrically connected to the data input/output circuit to achieve data import and export.

In some embodiments, the data input/output circuit can be disposed on the side of the second circuit board 220 facing the first circuit board 210. The data input/output circuit is accompanied by high-frequency clock signals and rapidly changing data signals during data transmission. In different technical fields, the definition of high frequency varies. In the definition of high-speed circuits, if the clock frequency in an electronic system reaches or exceeds 50 MHz, the circuit system is considered a high-speed circuit, and the clock frequency can be considered high frequency. The high frequency mentioned in this specification can refer to this definition. High-frequency signals can cause many problems for circuit systems. For example, electromagnetic radiation generated by high-frequency signals may cause crosstalk within the circuit system, resulting in timing errors or affecting the sensitivity of components. For example, electromagnetic waves generated by high-frequency signals may radiate externally through component surfaces or interfaces, thereby causing electromagnetic interference to other electronic devices. Moreover, circuits with high-frequency signals are more likely to couple with external electromagnetic radiation, thereby forming electromagnetic interference to the data input/output circuit. To solve the above problems, the headphone 001 provided in this specification can perform signal shielding on the data input/output circuit.

In some embodiments, a signal shielding component 300 can be installed above the entire data input/output circuit, or above part of the data input/output circuit, to at least partially block the electromagnetic radiation generated during audio data transmission. At the same time, it also reduces the interference that external electromagnetic radiation may cause to the data input/output circuit. In some embodiments, the signal shielding component 300 can be a semi-enclosed metal cover with one open side, with the open side facing the data input/output circuit and installed above it, and in contact with the second circuit board 220. In some embodiments, the signal shielding component 300 uses metal materials with low resistivity, utilizing eddy currents generated in the metal to form a counteracting effect against external electromagnetic waves, thereby achieving a shielding effect. The signal shielding component 300 is grounded.

In some embodiments, a conductive buffer pad can be disposed between the first circuit board 210 and the signal shielding component 300. The conductive buffer pad is in contact with the first circuit board 210 and the signal shielding component 300 to increase the electrical connection of the ground lines between the first circuit board 210 and the second circuit board 220, thereby reducing the signal loop area between the two boards. Since the outer surface of the conductive buffer pad is a conductive layer, it can electrically connect the signal shielding component with the first circuit board 210, which also establishes a grounding connection between the second circuit board 220 and the first circuit board 210. The signal loop area is reduced, and electromagnetic radiation in the circuit is suppressed. On the other hand, since the conductive buffer pad is made of buffer material, when disposed between the first circuit board 210 and the second circuit board 220, it can provide support and buffer functions. In some embodiments, the conductive buffer pad is adhered to the surface of the signal shielding component 300. In some embodiments, the conductive buffer pad can be conductive foam.

In some embodiments, the memory 221 can be disposed on the side of the second circuit board 220 away from the first circuit board 210. The data input/output circuit is disposed between the first circuit board 210 and the second circuit board 220, and is also covered with the signal shielding component 300 and conductive buffer pad, which already occupies a large area. Therefore, the memory 221 can be installed on the other side of the second circuit board 220 to control the area of the second circuit board 220. On the other hand, disposing the data input/output circuit and the memory 221 on opposite sides of corresponding positions on the second circuit board 220 can shorten the routing between them, thereby reducing signal delay.

The headphone 001 provided in this specification has a reasonable layout for the data unit. On one hand, it can make full use of the layout space on both sides of the second circuit board 220, thereby reducing the area of the second circuit board 220 itself; on one hand, the dual-layer circuit board structure enables the combined use of the signal shielding component 300 and conductive buffer pad between the two circuit boards, increasing the grounding area of the two boards and reducing the signal loop area, thereby reducing external electromagnetic radiation; on the other hand, the conductive buffer pad can provide physical support and buffer for the first circuit board 210, maintaining relative parallelism and relative stability between the two circuit boards.

As shown in FIG. 3, the circuit board compartment 010 may further include a button(s) 400. For example, the circuit board compartment 010 includes the play button, pause button, etc., of an MP3 player. The number of buttons 400 can be one or more. **In** some embodiments, the button 400 can be a volume adjustment button. The button 400 may include a button cap, an elastic member, and a switch circuit, the switch circuit is electrically connected to the first circuit board 210 or the second circuit board 220. The button cap includes a cap portion and a stem portion, the cap portion is at least partially exposed outside the housing 100 to receive a user's pressing operation. The stem portion passes through a button hole, and when not pressed, there is no elastic force between the stem portion and the elastic member; when pressed, the pressure is transmitted through the stem portion to the elastic member, causing the elastic member to move toward the switch circuit. The switch circuit converts the received user button operation into an electrical signal and transmits it to the control element on the first circuit board 210. In some embodiments, when viewed along the direction of the gap left between the first circuit board 210 and the second circuit board 220, the one or more buttons 400 are wholly or partially disposed between the first circuit board 210 and the second circuit board 220, at least the switch circuit portion is located between the two circuit boards. Correspondingly, the housing 100 also includes a corresponding number of button holes at corresponding positions. Thus, in the assembled headphone, each button 400 is inserted into its corresponding button hole. As shown in FIG. 3, the thickness of the button should be less than or equal to the distance between the first circuit board 210 and the second circuit board 220, so that the button 400 can move freely in the gap between the first circuit board 210 and the second circuit board 220 without getting stuck when pressed, the thickness is the maximum distance of the switch circuit along the direction perpendicular to the surface of the first circuit board.

The headphone 001 provided in this specification has a reasonable layout for the buttons. At least one button is wholly or partially disposed between the two circuit boards, fully utilizing the gap between the two boards without occupying additional vertical space.

Next, the dual-layer circuit board structure 200 of the headphone 001 provided in this specification and how it maintains positional stability within the circuit board compartment 010 will be described.

FIG. 4 shows a schematic diagram of the internal structure of the circuit board compartment 010 according to some embodiments provided in this specification. The housing 100 of the circuit board compartment 010 may include at least one positioning post 111. In this specification, it is exemplified that the at least one positioning post is located on the first housing 110, but it should be understood that the one or more positioning posts may be located on the first housing 110 or on the second housing 120. The first circuit board 210 and the second circuit board 220 may be provided with one or more positioning holes and/or one or more positioning notches. These positioning holes or positioning notches may be wholly or partially provided on one of the first circuit board 210 and the second circuit board 220. For example, in some embodiments, the first circuit board 210 is provided with at least one positioning hole and/or at least one positioning notch, while the second circuit board 220 is not provided with any positioning holes or positioning notches. In some embodiments, the second circuit board 220 is provided with at least one positioning hole and/or at least one positioning notch, while the first circuit board 210 is not provided with any positioning holes or positioning notches. In some embodiments, the first circuit board 210 is provided with at least one positioning hole and/or at least one positioning notch, and the second circuit board 220 is also provided with at least one positioning hole and/or at least one positioning notch. Furthermore, the first housing 110 is provided with one or more positioning posts 111. These positioning posts 111 are inserted into the one or more positioning holes or positioning notches to restrict the movement of the first circuit board 210 and the second circuit board 220 relative to the circuit board compartment 010 in the direction of their respective board surfaces, thereby fixing the first circuit board 210 and the second circuit board 220 in the direction of their respective board surfaces.

In some embodiments, at least one of these positioning posts 111 has the structure of a target positioning post. The target positioning post includes a post body and an enlarged post head, the post body is fixedly connected to the first housing 110 and passes through the first circuit board 210 and the second circuit board 220, and the post head abuts against the side of the first circuit board 210 or the second circuit board 220 that is farther from the first housing 110, so as to fix the first circuit board 210 and the second circuit board 220 along the axial direction of the post body. **In** other words, the enlarged post head of the target positioning post can restrict the movement of the first circuit board 210 and the second circuit board 220 relative to the circuit board compartment 010 in a direction perpendicular to the first circuit board 210 or the second circuit board 220. **In** some embodiments, the target positioning post can be a hotmelt post, the post head deforms after being hot-melted to fix the dual-layer circuit board structure 200. The target positioning post can also be a screw, the threaded portion corresponds to the post body, and the nut portion corresponds to the post head. Of course, the target positioning post can also be in other forms of structure.

As shown in FIG. 4, the first housing 110 may be provided with three positioning posts 111-1, 111-2, and 111-3, all of which are target positioning posts and are evenly arranged around the accommodation space. On one hand, the even arrangement of the three positioning posts can stably restrict the movement of the first circuit board 210 and the second circuit board 220 relative to the circuit board compartment 010 in the direction of the first circuit board 210 or the second circuit board 220. On the other hand, the even arrangement also allows the post heads to exert a more uniform force on the circuit boards when constraining them along the axial direction of the post bodies, which helps the dual-layer circuit board maintain parallelism stably.

In some embodiments, the position where at least one positioning post contacts at least one positioning hole/positioning notch on the side of the first circuit board 210 or the second circuit board 220 closer to the first housing 110 may be applied with adhesive to fix the side of the first circuit board 210 or the second circuit board 220 closer to the first housing 110 along the axial direction of the positioning post.

Furthermore, the circuit board compartment 010 of the headphone 001 provided in this specification may also include an accommodation cavity. The accommodation cavity is used to accommodate and restrict the movement of components on the circuit board in the direction of the circuit board, thereby restricting the movement of the circuit board on which the components are located in the direction of the board surface. **In** some embodiments, an accommodation cavity may be provided in the first housing 110 of the circuit board compartment 010 to accommodate a corresponding target component and restrict the movement of the circuit board on which the target component is located in the direction of the board surface. The target component is the component with the highest height on the circuit board surface in the direction perpendicular to the board surface. For example, the memory on the second circuit board 220 is higher than other electronic components on the same board and can serve as an "anchor point" for further fixing the second circuit board 220 when assembled into the circuit board compartment. Accordingly, an accommodation cavity with a matching shape can be provided at the corresponding position on the inner wall of the circuit board compartment 100, so that when the second circuit board 220 is assembled into the circuit board compartment 110, it fits precisely into the accommodation cavity, further fixing the second circuit board 220.

To ensure that the target component can be smoothly engaged in the accommodation cavity without affecting other components, such as those on the circuit board itself, the depth of the accommodation cavity is designed to be less than or equal to the height of the target component relative to the surface of its circuit board. This design, on one hand, allows the target component to abut against the first housing 110, thereby restricting the movement of the target component toward the first housing 110 in the direction perpendicular to the board surface. On the other hand, it prevents the top edge of the accommodation cavity wall from abutting against the circuit board, avoiding potential damage to the circuit board. It can be understood that the number of accommodation cavities can be one or multiple, and the number of target components can also be one or multiple.

In the above application scenario, the target component is the memory 221, which is disposed on the side of the second circuit board 220 facing away from the first circuit board 210. The memory 221 has a larger and more regular shape on the side facing outward from the dual-layer circuit board structure 200, so placing it in the accommodation cavity can provide better stability for the dual-layer circuit board structure 200.

To further enhance the structural stability of the components in the product after assembly and improve product quality, the headphone 001 provided in this specification may further include a buffer member. In some embodiments, the buffer member may be located in the gap formed between the shorter of the two circuit boards and the housing 100 of the circuit board compartment 010, relative to the longer circuit board. In some embodiments, the buffer member is located between the first circuit board 210 and the housing 100 of the circuit board compartment 010, abutting against both the first circuit board 210 and the housing 100, providing support for the first circuit board 210 in the direction perpendicular to its board surface. FIG. 5 illustrates a schematic diagram of the dual-layer circuit board structure according to some embodiments provided in this specification. As shown in FIG. 5, the buffer member 500 is adhered to the side of the first circuit board 210 facing the second circuit board 220 and protrudes relative to the second circuit board 220. The buffer member 500 is located in the gap formed between the second circuit board 220 and the housing 100 of the circuit board compartment 010, providing support between the first circuit board 210 and the housing 100. The shape and size of the buffer member 500 can be adjusted based on the relative positional difference between the first circuit board 210 and the second circuit board 220. The thickness of the buffer member 500 is not less than the distance between the first circuit board 210 and the housing 100 to provide support between the first circuit board 210 and the housing 100.

The dual-layer circuit board structure 200 of the headphone 001 provided in this specification can be stably assembled in the circuit board compartment 010 due to the following: On one hand, the housing 100 of the circuit board compartment 010 may be provided with positioning posts and/or an accommodation cavity to restrict the movement of the dual-layer circuit board structure 200 in the direction of the board surface; on the other hand, the housing 100 of the circuit board compartment 010 may be provided with target positioning posts and/or a buffer member to restrict the movement of the dual-layer circuit board structure 200 in the direction perpendicular to the board surface.

In actual production, the iterative update speed of products, especially electronic devices, is very fast. If the housing is redesigned and new molds are created for each update, the cost is extremely high. The headphone 001 provided in this specification can utilize the housing of an existing model headphone without replacing it, and by adopting a dual-layer circuit board design, a larger circuit board area can be accommodated in the circuit board compartment 010 of the headphone 001, thereby reducing mold-making costs. For ease of description, the headphone 001 provided in this specification is referred to as the first model headphone, while the existing model headphone is referred to as the second model headphone. In some embodiments, the circuit board compartment 010 of the first model headphone is identical to that of the second model headphone at least in terms of the shape and dimensions of the circuit board compartment 010. Furthermore, the first model headphone can be directly upgraded based on the first circuit board of the second model headphone, with functional modules that need to be updated or added being placed on the second circuit board 220, further reducing circuit design costs. In some embodiments, the circuit board compartment 010 of the second model headphone may not include a second circuit board, i.e., it may contain only one circuit board, or it may include a replaceable second circuit board. In some embodiments, specific functional modules, such as those prone to damage or requiring rapid iteration, can be placed on the second circuit board. This approach minimizes the coupling between the functional modules on the second circuit board and those on the first circuit board during circuit design, thereby reducing the difficulty and cost of inspection and updates for the headphone, and improving the maintainability and scalability of the headphone.

In summary, the headphone 001 provided in this specification can incorporate a dual-layer circuit board structure 200 within the limited space of the circuit board compartment 010, achieving an expansion of the circuit board area. The dual-layer circuit board structure 200 maximizes the use of the lateral space of the accommodation space while improving the utilization rate of the vertical space of the accommodation space. Additionally, by leveraging the structural characteristics of the dual-layer circuit board, a conductive buffer structure is placed between the two circuit boards to increase grounding points, thereby reducing the signal loop area and minimizing external electromagnetic radiation. Furthermore, the headphone 001 provided in this specification can maintain the stability of the dual-layer circuit board structure 200 within the circuit board compartment 010. Moreover, the headphone 001 provided in this specification can utilize the housing of an existing model headphone to assemble the dual-layer circuit board structure 200, which can reduce production costs.

The foregoing describes specific embodiments of the present application. Other embodiments are within the scope of the appended claims. In some cases, the actions or steps recited in the claims may be performed in an order different from that in the embodiments and still achieve the desired results. Additionally, the processes depicted in the drawings do not necessarily require the specific order shown or a continuous order to achieve the desired results. In certain implementations, multitasking and parallel processing are also possible or may be advantageous.

In summary, after reading this detailed disclosure, a person skilled in the art will understand that the foregoing detailed disclosure may be presented by way of example only and may not be limiting. Although not explicitly stated here, a person skilled in the art will understand that the present application is intended to encompass various reasonable changes, improvements, and modifications to the embodiments. These changes, improvements, and modifications are intended to be proposed by the present application and are within the spirit and scope of the exemplary embodiments of the present application.

In addition, certain terms in this application have been used to describe embodiments of the present application. For example, "one embodiment," "an embodiment," and/or "some embodiments" mean that a particular feature, structure, or characteristic described in connection with the embodiment may be included in at least one embodiment of the present application. Therefore, it may be emphasized and should be understood that two or more references to "an embodiment" or "one embodiment" or "an alternative embodiment" in various parts of this application do not necessarily all refer to the same embodiment. Furthermore, particular features, structures, or characteristics may be appropriately combined in one or more embodiments of the present application.

It should be understood that in the foregoing description of the embodiments of the present application, to aid in understanding a feature and for the purpose of simplifying the present application, various features are combined in a single embodiment, drawing, or description thereof. However, this does not mean that the combination of these features is necessary, and it is entirely possible for a person skilled in the art, upon reading the present application, to identify certain components as separate embodiments for understanding. In other words, embodiments in the present application can also be understood as an integration of multiple secondary embodiments. This holds true even when the content of each secondary embodiment includes fewer than all the features of a single foregoing disclosed embodiment.

Each patent, patent application, publication of a patent application, and other materials, such as articles, books, specifications, publications, documents, articles, etc., cited herein, except for any historical prosecution documents to which it relates, which may be inconsistent with or any identities that conflict, or any identities that may have a restrictive effect on the broadest scope of the claims, are hereby incorporated by reference for all purposes now or hereafter associated with this document. Furthermore, in the event of any inconsistency or conflict between the description, definition, and/or use of a term associated with any contained material, the term used in this document shall prevail.

Finally, it should be understood that the embodiments of the application disclosed herein are illustrative of the principles of the embodiments of the present application. Other modified embodiments are also within the scope of the present application. Therefore, the embodiments disclosed in the present application are merely examples and not limitations. A person skilled in the art may adopt alternative configurations based on the embodiments in the present application to implement the application. Thus, the embodiments of the present application are not limited to the embodiments precisely described in the application.

## Claims

1. An ear hook headphone, **characterized by** comprising:
a speaker unit, configured to convert an input into a sound;
a circuit board compartment, comprising an accommodation space; and
a first circuit board, a second circuit board, and a connector, wherein
the first circuit board and the second circuit board are connected within the accommodation space via the connector, forming a dual-layer circuit board structure to utilize a vertical space of the circuit board compartment perpendicular to a surface of the first circuit board.

2. The headphone according to claim 1, **characterized in that**
the connector is a board-to-board connector, the first circuit board and the second circuit board are arranged in parallel on two sides relative to the board-to-board connector, forming the dual-layer circuit board structure; or
the connector comprises a flexible circuit board, the first circuit board and the second circuit board are foldably connected via the flexible circuit board and arranged in parallel, forming the dual-layer circuit board structure.

3. The headphone according to claim 1 or 2, **characterized in that** in a board surface direction of the first circuit board, a ratio of an overlapping area of the first circuit board and the second circuit board to a union area of the first circuit board and the second circuit board is greater than or equal to 0.2.

4. The headphone according to any one of claims 1-3, **characterized in that** a ratio of a maximum cross-sectional area of the accommodation space to a/the union area of the first circuit board and the second circuit board in a/the board surface direction of the first circuit board is less than or equal to 1.5.

5. The headphone according to any one of claims 1-4, **characterized in that** a ratio of a thickness of the circuit board compartment to a thickness of the dual-layer circuit board structure is less than or equal to 1.5, wherein
the thickness of the dual-layer circuit board structure is a maximum distance between the first circuit board and components on the first circuit board and the second circuit board and components on the second circuit board in a direction perpendicular to a/the board surface direction of the first circuit board.

6. The headphone according to any one of claims 1-5, **characterized in that** a/the thickness of the circuit board compartment is in a range of 0.6 centimeters to 1 centimeter.

7. The headphone according to any one of claims 1-6, **characterized in that** a length of the circuit board compartment is in a range of 3 centimeters to 4 centimeters.

8. The headphone according to any one of claims 1-7, **characterized in that** the second circuit board comprises a data unit;
the data unit and the first circuit board perform mutual signal transmission through the connector during operation, wherein the first circuit board and the second circuit board are arranged in dual layers.

9. The headphone according to claim 8, **characterized in that** the data unit comprises:
a data input and output circuit, disposed on a side of the second circuit board facing the first circuit board; and
a memory, storing audio data, electrically connected to the data input and output circuit, the memory being disposed on a side of the second circuit board away from the first circuit board.

10. The headphone according to any one of claims 1-9, further comprising: an MP3 module, wherein the MP3 module comprises at least a portion of the second circuit board.

11. The headphone according to claim 9 or 10, further comprising: a signal shielding component, at least partially covering the data input and output circuit to at least partially block electromagnetic radiation generated during audio data transmission.

12. The headphone according to claim 11, further comprising:
a conductive buffer pad, located between the first circuit board and the signal shielding component and abutting against the first circuit board and the signal shielding component, to enhance an electrical connection of ground lines of the first circuit board and the second circuit board, thereby reducing a signal loop area between the first circuit board and the second circuit board.

13. The headphone according to any one of claims 1-12, **characterized in that** a housing of the circuit board compartment comprises at least one positioning post; and
the first circuit board and the second circuit board each comprise at least one positioning hole and/or at least one positioning notch, wherein
the at least one positioning post is inserted through the at least one positioning hole or the at least one positioning notch to fix the first circuit board and the second circuit board in respective board surface directions thereof.

14. The headphone according to claim 13, **characterized in that** the at least one positioning post comprises at least one target positioning post, and the at least one target positioning post comprises a post body and an enlarged post head;
the post body is fixedly connected to the housing and passes through the first circuit board and the second circuit board; and
the post head abuts against a side of the first circuit board or the second circuit board that is far away from the housing, so as to fix the first circuit board and the second circuit board along an axial direction of the post body.

15. The headphone according to any one of claims 1-14, **characterized in that** at least one accommodation cavity is disposed inside a/the housing of the circuit board compartment to accommodate at least one target component and to restrict movement of the at least one target component along a board surface direction of a circuit board;
the target component is a component with a greatest height in a direction perpendicular to the board surface direction of the circuit board; and
a depth of the accommodation cavity is less than or equal to a height of the target component relative to a board surface of the circuit board.

16. The headphone according to claim 15, **characterized in that** the target component is a memory, and the memory is disposed on a/the side of the second circuit board away from the first circuit board.

17. The headphone according to any one of claims 1-16, further comprising: a buffer member, wherein the buffer member is disposed between the first circuit board and a/the housing of the circuit board compartment, and is in contact with both the first circuit board and the housing.

18. The headphone according to any one of claims 1-17, further comprising: at least one button, wherein the at least one button is at least partially disposed between the first circuit board and the second circuit board, and is electrically connected to the first circuit board or the second circuit board, wherein
a/the housing further comprises at least one button hole, and the at least one button is inserted through the at least one button hole.

19. The headphone according to claim 18, **characterized in that** a thickness of the button is less than or equal to a distance between the first circuit board and the second circuit board.

20. The headphone according to any one of claims 1-19, **characterized in that** the headphone is a first model headphone, and
the circuit board compartment has same shape and size as a circuit board compartment of a second model headphone, and the circuit board compartment of the second model headphone does not comprises a second circuit board.
